# EUROPEAN PATENT SPECIFICATION

(11) **EP 0 355 769 B1**
(45) Date of publication and mention of the grant of the patent: **15.11.1995**
(21) Application number: 89115381.9
(22) Date of filing: 21.08.1989
(51) Int. Cl.: G06F 1/10

(54) **Clock supply circuit**
Taktversorgungsschaltung
Circuit fournissant un signal d'horloge

(30) Priority: 19.08.1988 JP 205868/88
(43) Date of publication of application: 28.02.1990
(73) Proprietor: KABUSHIKI KAISHA TOSHIBA, Kawasaki-shi, Kanagawa-ken 210 (JP)
(72) Inventor: Nishimura, Akira Soei Bldg. 301, Yokohama-shi Kanagawa-ken (JP); Watanabe, Hiroyuki, Tokyo (JP); Masuda, Eiji, Kawasaki-shi Kanagawa-ken (JP)
(74) Representative: Lehn, Werner, Dipl.-Ing.

(56) References cited:
- EP-A- 0 181 059
- EP-A- 0 258 975
- IEEE JOURNAL OF SOLID-STATE CIRCUITS, vol. SC-21, no. 2, April 1986, pages 240-246; EBY G. FRIEDMAN et al.: "Design and analysis of a hierarchical clock distribution system for synchronous standard cell/macrocell VLSI"

## Description

### CLOCK SUPPLY CIRCUIT

### BACKGROUND OF THE INVENTION

### Field of the Invention

The present invention relates to a clock supply circuit as specified in the preamble part of claim 1.

### Description of the Prior Art

A clock supply circuit as specified in the preamble part of claim 1 is known from the publication IEEE Journal of solid-state circuits, Vol. SC-21, No. 2, April 1986, pages 240-246.

EP-A-1 181 059 discloses dealing with the clock skew problem in a semiconductor integrated circuit by use of flip-flops.

In a clock supply circuit in large-scale integration (LSI), the number of flip-flops (F/Fs) which are connected to clock lines is extremely large, and the length of the lines between these F/Fs is long. Therfore the design of a clock system becomes difficult, and other various problems occur. For example, a delay between two of the F/Fs or an inner clock skew and a time delay while a clock signal supplied from the outside of a chip is inputted into the F/Fs in the chip or an outer clock skew are increased. When the outer clock skew is increased, the performance of LSI is lowered. Accordingly, it is desired to make the outer clock skew as small as possible.

While, when the inner clock skew (hereinafter called only clock skew) is increased, a data transfer error occurs between F/Fs which are connected in series and the error causes wrong operation of the LSI.

For example, in the case that two F/Fs are connected in series, when the degree of a signal transmission delay between a Q output of F/F in a front stage and a D input of F/F in a rear stage is smaller than the clock skew, the F/F in the rear stage inputs the Q output in the same clock cycle, so that the wrong operation occurs.

To avoid the occurrence of the phenomenon, the delay between the Q output and the D input of the two F/F is controlled larger than the clock skew. However, when the value becomes increased, the operation speed of the LSI becomes slower. Accordingly, it is required to control the clock skew as small as possible.

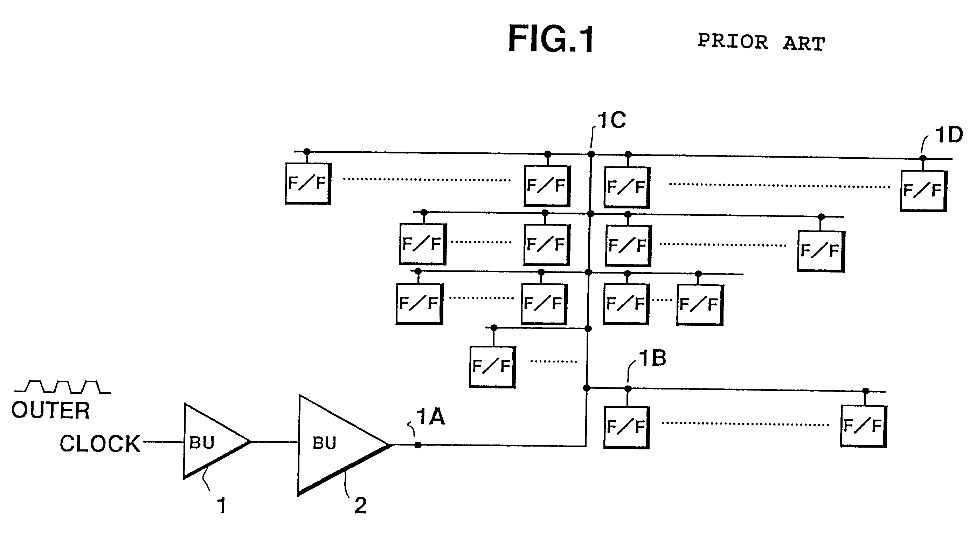

Fig. 1 shows an example of a centralized, system which is also a clock drive system of a group of F/Fs according to the prior art. In the same drawing, means flip-flop and BU means clock buffer or buffer. Each the F/F is so connected to a buffer (BU) 1 and a buffer (BU) 2 as to construct a branch structure. The outer clock is inputted into the buffer 1 first, then inputted into the buffer 2, thereafter transmitted into each F/F from the buffer 2. By arranging the inner clock lines into such a branch form, a difference in the line distance between the buffer 2 to each F/F is made small, so that the delay between the lines can be controlled to be relatively small. Accordingly, the clock skew can be also controlled to be small.

However, when the circuit scale of LSI becomes so large as is seen recently, the number of F/Fs in some chips reaches several thousands, the total length of the clock lines becomes collectively large, and the difference in the line length from the output of the buffer 2 to each F/Fs also becomes large.

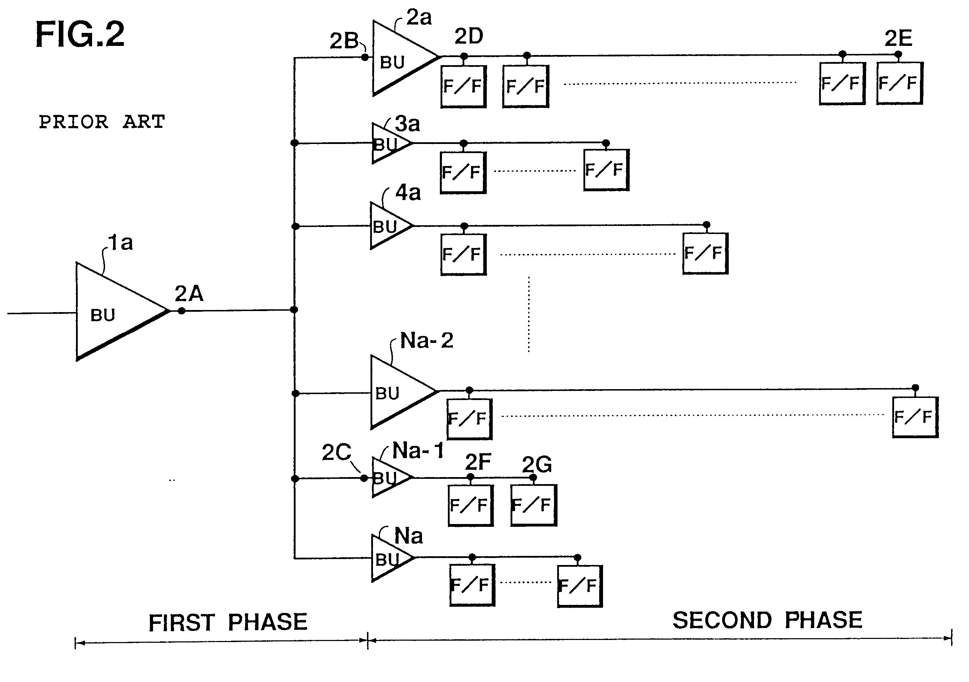

Fig. 2 shows an example of a distributed drive system which is another clock drive system according to the prior art.

In the same drawing, as similar to Fig. 1, F/F means flip-flop and BU₁ₐ, BU₂ₐ, ..., BU_{Na-1}, and BU_{Na} (N is a natural number of 1 or more) mean buffer. Each F/F is connected in series to each of the BU₂ₐ, BU₃ₐ, ..., and BU_{N3}. In this example, the buffers are composed in two phases. The buffer 1a in a first phase drives the buffers 2a, ..., to Na (N is a natural number of 2 or more) in a second phase, and also drives each of the F/Fs which are dependent on each buffer.

In the drive system, for example, drive ability β₂ and β_{Na-1} of the buffer 2a and the buffer Na-1 which respectively have different numbers of F/Fs are determined in the following manner.

Namely, a delay time t_{2A2B} between a point 2A and a point 2B, and a delay time T_{2A2C} between a point 2A and a point 2C are determined, and then load C_{2D2E} between a point 2D and a point 2E in a clock line, and load C_{2F2G} between a point 2F and a point 2G in another clock line are determined, then β₂ and β_{Na-1} are so determined as to satisfy the following equation:${\text{t}}_{\text{2A2B}} {\text{+ T (β₂, C}}_{\text{2D2E}} {\text{) = t}}_{\text{2A2C}} {\text{+ T (β}}_{\text{Na-1}} {\text{, C}}_{\text{2F2G}} \text{) = Constant, (where T is delay time for driving each load).}$

In the centralized drive system shown in Fig. 1, for example, the linear length from a point 1A to a point 1B is different that from the point 1A to a point 1D. Accordingly, a clock delay caused by RC delay on the line occurs, and a clock skew corresponding thereto also occurs. Namely, the clock skew can not be avoided by the drive system in principle. Particularly, when the scale of the LSI is large, the magnitude of the clock skew can not be ignored. Moreover, since the system is a collective drive system, it is necessary for the buffer 2 to have a big drive ability to operate a plurality of F/Fs. Accordingly, a large amount of current should flow locally in the buffer, thus noise and wrong operation are likely to be caused.

While, in the distributed drive system in Fig. 2, a complex calculation is required in order to minimize the clock skew, and a plurality of the buffers respectively having different drive ability are also required, the circuit design of the system becomes very complex.

While, when the number of the F/Fs which is connected to a specific buffer becomes large, a clock skew which occurs between both of the terminals of these F/Fs can not be ignored.

### SUMMARY OF THE INVENTION

It is an object of the present invention to provide a clock supply circuit of the type initially mentioned hereinabove, which can effectively control an inner clock skew in order to solve the above-mentioned problem.

This object is achieved by providing the features of the characterizing part of claim 1. Further improvements are specified in the sub-claims.

A clock supply circuit according to the present invention may comprise a first phase which includes a first buffer and at least one line from a predetermined point on the output side of the first buffer to an input point of each second buffer in each channel, and a dependent phase which is composed of each second buffer and a group of flip-flops which is dependent thereon, and-the circuit is so constructed as to uniformalize line length and capacitive load or F/F in each phase, to unify drive ability of the buffers in the dependent phase, and adjust load capacity by providing extra capacities for adjustment of a clock skew.

By the construction of the clock supply circuit as mentioned above, uniformalized load can be driven by the buffers having the same drive ability , so that the clock skew can be reduced.

These and other objects, features and advantages of the present invention will be more apparent from the following description of a preferred embodiment, taken in conjunction with the accompanying drawings.

### BRIEF DESCRIPTION OF THE DRAWINGS

Fig. 1 is a diagram of a clock supply circuit of a centralized drive system according to the prior art,
Fig. 2 is a diagram of a clock supply circuit of a distributed drive system according to the prior art,
Fig. 3 is a diagram of a clock supply circuit using a drive system that is a first embodiment of the present invention, and
Fig. 4 is a diagram of a clock supply circuit using a drive system that is a second embodiment of the present invention.

### DETAILED DESCRIPTION OF THE EMBODIMENTS

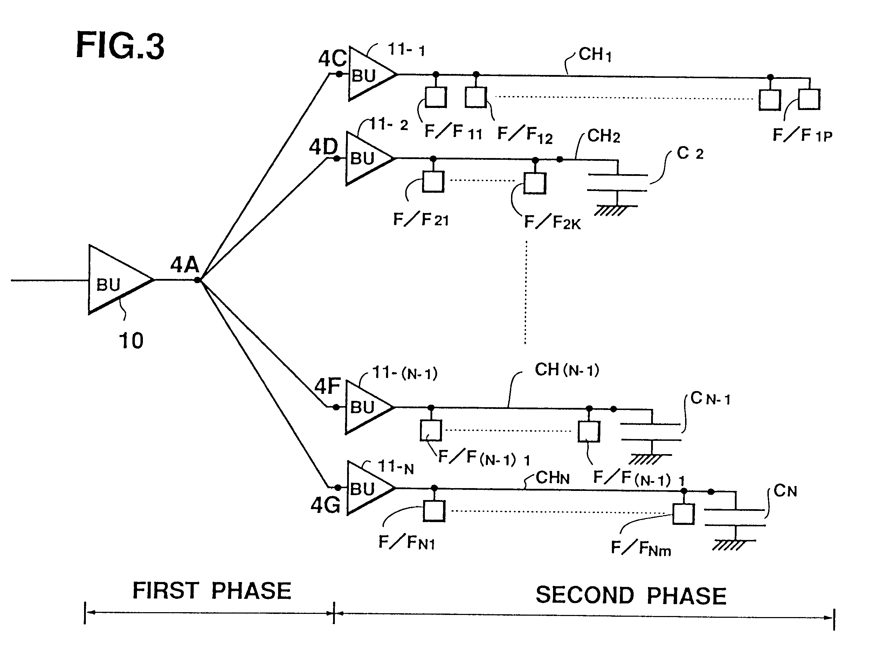

Fig. 3 shows a first embodiment of a clock supply circuit according to the present invention. In the drawing, CH_{N} (N is a natural number) means channel.

In the drawing, each line length, and each line width from a point 3A on the output side of a buffer (BU) 10 to each of buffers 11₋₁, 11₋₂, ..., 11-_{(N-1)}, to 11_{-N} (N is a natural number) in a first phase are respectively constructed to be the same. Moreover, in a second phase, the drive ability of the buffers 11₋₁, 11₋₂, ..., 11_{-(N-1)}, and 11_{-N} are respectively arranged to be the same. The number of F/F of each channel (CH_{N}), e.i. the number of each of F/F₁ₘ, F/F₂ₘ, ..., F/F_{(N-1)m}, to F/F_{Nm} (m = 1, 2, ..., m) connected to each buffer, and each linear length for connecting these in a second phase are respectively different. Namely, the line conditions from a point 4A on the output side of a buffer 10 to points 4C, 4D, ..., 4F, and 4G which are respectively input points of buffers 11₋₁, 11₋₂, and 11₋₃, ..., 11_{-N} dispersed into the respective channels in the first phase are the same. For example, in the second phase of the same drawing, a channel CH₁ has the largest number of F/Fs in these channels. In this case, load capacities C₂, C₃, ..., C_{N-1}, and C_{N} for RC delay adjustment are respectively connected to the end terminals of channels CH₂, CH₃, ..., and CH_{N} to which belong the buffers 11₋₂, 11₋₃, ..., and 11_{-N} respectively having the smaller number of F/Fs on the basis of the number of F/F₁ₚ (p = 1, 2, ..., P) of the buffer 11₋₁ in the channel CH₁. Each of the load capacities has an adjusted value in accordance with the number of F/Fs which are connected to each of the buffer 11₋₂, 11₋₃, ..., and 11_{-N} in each of the channels CH₂, CH₃, ..., and CH_{N}, furthermore it is so adjusted as to be substantially the same delay as a signal delay in the standard channel CH₁ in consideration of the linear length of the respective channels CH₂, CH₃, ..., and CH_{N}.

Namely, the load capacity C_{N} is calculated by the following equation:
C_{N} = Difference in the stray capacity of the line to the standard channel + a gate capacity corresponding to the number of F/Fs which is less than the standard channel.

As a manner of embodying the respective load capacity, if it can be realized as a gate capacity of a MOS transistor, the design becomes easy and an area overhead becomes minimized. With respect to the line length of the standard channel CH₁ having a largest number of F/Fs, it is required to determine the range from just after the output to the end terminal of F/F where a bad influence of the clock skew by the RC delay does not occur.

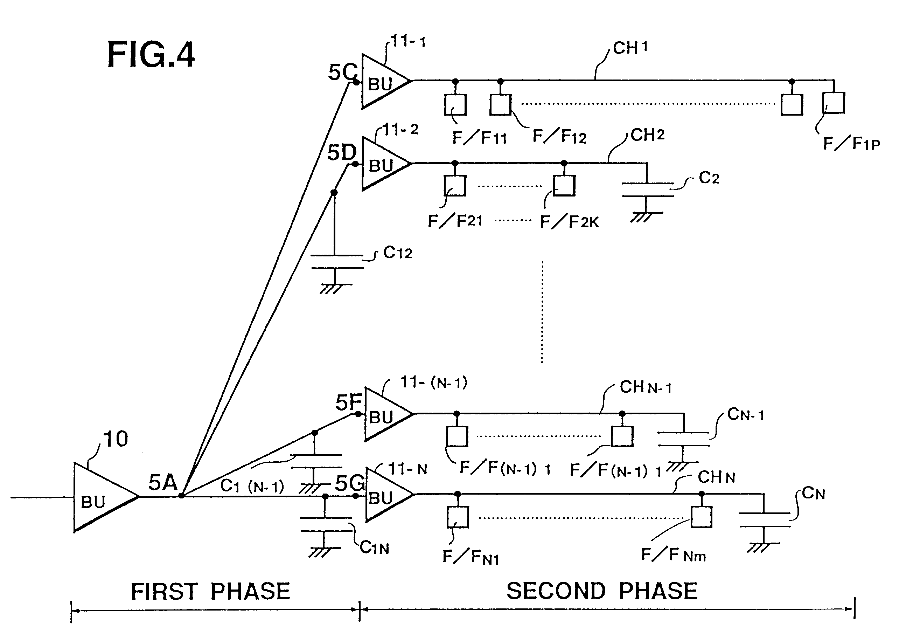

Fig. 4 shows a second embodiment of a clock supply circuit according to the present invention. In this embodiment, the construction of a second phase is the same as that of the embodiment in Fig. 3, and the determination manner of the values of the capacities for the respective adjustments is also the same as that of the embodiment in Fig. 3, thus the detailed description on the matter will be omitted herein.

In this embodiment, input line lengths from a point 5A on the output side of a first buffer 10 each of points 5C, 5D, ..., 5F, and 5G which are respectively input points of buffers 11₋₁, 11₋₂, ..., 11_{-(N-1)}, and 11_{-N} in a first phase are different from one another. In order to minimize a clock skew caused by the differences of the line length, there are provided adjustment capacities C₁₂, C₁₃, ..., and C_{1N} for prevention of the clock skew caused by the RC delay of the input lines having different lengths on the basis of a specific buffer having a longest input line, for example, the buffer 11₋₁ in the same drawing. In this case, each value of the respective adjustment capacities can be determined in accordance with the respective shortages of capacity in the input lines.

Incidentally, in the above embodiments, the cases in which the number of the phases is two are described, however, the present invention is not limited by the number of the phases.

As mentioned above, in the clock supply circuit according to the present invention, the construction thereof is divided into the first phase which includes the lines from the first buffer to the input points of the respective buffer which belong to the respective channels in the next phase, and the second phase comprises the respective buffers and the respective channels including the F/Fs which are connected to thereon, and the F/Fs as the load are driven in the substantially uniformalized state of line conditions in the respective phases. Therefore, the clock skew can be controlled to be small.

Since the respective buffers in the respective channels in the second phase may be the same kind, and may have the same performance or the same drive ability, it becomes easy to design the circuit.

Moreover, even when there are differences in the line length and the number of the F/F which are dependent on the respective channels in the first phase or the second phase or in the both, the adjustment can be easily achieved by adding adjustable capacities so as to adjust the states of the circuit of the respective channels or the line conditions thereof into substantially uniform. As the result, the clock skew can be controlled to be uniform and small even when the drive ability of the respective buffers in the respective channels fluctuate a little.

## Claims

1. A clock supply circuit, comprising
(a) a primary buffer (10) for driving a clock signal;
(b) a first buffer (11-1) connected to said primary buffer (10) through a first line for receiving the clock signal from said primary buffer (10);
(c) at least one second buffer (11-2; 11-(N-1); 11-N) connected to said primary buffer (10) through at least one second line for receiving the clock signal from said primary buffer (10); said first and second lines being equal in length,
**characterized** by
(d) a first channel (CH1) connected to said first buffer (11-1) for supplying the clock signal from said first buffer (11-1) to more than one first flip-flops (F/F11 to F/F1p) connected to said first channel (CH1);
(e) at least one second channel (CH2; CH-(N-1); CH-N) respectively connected to said at least one second buffer (11-2; 11-(N-1); 11-N) for supplying the clock signal from said at least one second buffer (11-2; 11-(N-1); 11-N) to more than one second flip-flops (F/F21 to F/F2k; F/F(N-1)1 to F/F(N-1)n; F/FN1 to F/FNm) respectively connected to said at least one second channel (CH2; CH(N-1); CHN); and
(f) at least one circuit means (C2; C(N-1); CN) respectively connected to at least one second channel (CH2; CH(N-1); CHN) for substantially equalizing delays of the clock signals respectively passing through said first channel (CH1) and said at least one second channel (CH2; CH(N-1); CHN);
wherein
(g) said first buffer (11-1) and said at least one second buffer (11-2; 11-(N-1); 11-N) have the same drive ability;
(h) a total load of said first channel (CH1) is greater than a total load of said at least one second channel (CH2; CH-(N-1); CH-N), respectively, excluding said at least one circuit means (C2; C(N-1); CN); and
(i) said at least one circuit means (C2; C(N-1); CN) is a capacitance.

2. The clock supply circuit as claimed in claim 1, wherein said at least one circuit means (C2; C(N-1); CN) is connected to said at least one second channel (CH2; CH(N-1); CHN) at a side opposite to said at least one second buffer (11-2; 11-(N-1); 11-N), respectively.

3. A clock supply circuit, comprising
(a) a primary buffer (10) for driving a clock signal;
(b) a first buffer (11-1) connected to said primary buffer (10) through a first line for receiving the clock signal from said primary buffer (10);
(c) at least one second buffer (11-2; 11-(N-1); 11-N) connected to said primary buffer (10) through at least one second line for receiving the clock signal from said primary buffer (10);
**characterized** by
(d) a first channel (CH1) connected to said first buffer (11-1) for supplying the clock signal from said first buffer (11-1) to more than one first flip-flops (F/F11 to F/F1p) connected to said first channel (CH1);
(e) at least one second channel (CH2; CH-(N-1); CH-N) respectively connected to said at least one second buffer (11-2; 11-(N-1); 11-N) for supplying the clock signal from said at least one second buffer (11-2; 11-(N-1); 11-N) to more than one second flip-flops (F/F21 to F/F2k; F/F(N-1)1 to F/F(N-1)n; F/FN1 to F/FNm) respectively connected to said at least one second channel (CH2; CH(N-1); CHN); and
(f) at least one circuit means (C2; C(N-1); CN) respectively connected to at least one second channel (CH2; CH(N-1); CHN) for substantially equalizing delays of the clock signals respectively passing through said first channel (CH1) and said at least one second channel (CH2; CH(N-1); CHN);
wherein
(g) said first buffer (11-1) and said at least one second buffer (11-2; 11-(N-1); 11-N) have the same drive ability;
(h) a total load of said first channel (CH1) is greater than a total load of said at least one second channel (CH2; CH-(N-1); CH-N), respectively, excluding said at least one circuit means (C2; C(N-1); CN);
(i) said at least one circuit means (C2; C(N-1); CN) is a capacitance;
(j) at least one second circuit means (C12; C1(N-1); C1N) respectively connected to at least one second line for substantially equalizing delays of the clock signals respectively passing through said first line and said at least one second line;
wherein
(k) a total load of said first line is greater than a total load of said at least one second line excluding said at least one second circuit means (C12; C1(N-1); C1N), respectively; and
(l) said at least one second circuit means (C12; C1(N-1); C1N) is a capacitance.

4. The clock supply circuit as claimed in any of the preceding claims, wherein the total load of said first channel (CH1) is determined by its length and said first flip-flops (F/F11 to F/F1p) and the total load of said at least one second channel (CH2; CH(N-1); CHN) respectively is determined by its length and said at least one second flip-flops (F/F21 to F/F2k; F/F(N-1)1 to F/F(N-1)n; F/FN1 to F/FNm).

5. The clock supply circuit as claimed in any of claims 1 to 4, wherein said first channel (CH1) and said at least one second channel (CH2; CH(N-1); CHN) are equal in number of flip-flops respectively connected thereto, and differ in length.

6. The clock supply circuit as claimed in any of claims 1 to 4, wherein said first channel (CH1) and said at least one second channel (CH2; CH(N-1); CHN) are equal in length, and differ in number of flip-flops respectively connected thereto.

## Patentansprüche

1. Taktversorgungsschaltung, umfassend:
(a) einen Primärpuffer (10) zum Ansteuern eines Taktsignals;
(b) einen ersten Puffer (11-1), der mit dem Primärpuffer (10) durch eine erste Leitung zum Empfang des Taktsignals von dem Primärpuffer (10) verbunden ist;
(c) wenigstens einen zweiten Puffer (11-2; 11-(N-1); 11-N), der mit dem Primärpuffer (10) durch wenigstens eine zweite Leitung zum Empfang des Taktsignals von dem Primärpuffer (10) verbunden ist; wobei die ersten und zweiten Leitungen die gleichen Länge aufweisen;
**gekennzeichnet** durch
(d) einen ersten Kanal (CH1), der mit dem ersten Puffer (11-1) verbunden ist, zum Liefern des Taktsignals von dem ersten Puffer (11-1) an mehr als ein erstes Flip-Flop (F/F11 bis F/F1p), die mit dem ersten Kanal (CH1) verbunden sind;
(e) wenigstens einen zweiten Kanal (CH2; CH-(N-1); CH-N), der jeweils mit dem wenigstens einen zweiten Puffer (11-2; 11-(N-1); 11-N) verbunden ist zum Liefern des Taktsignals von dem wenigstens einen zweiten Puffer (11-2; 11-(N-1); 11-N) an mehr als ein zweites Flip-Flop (F/F21 bis F/F2k; F/F(N-1)1 bis F/F/N-1)n; F/FN1 bis F/FNm), die jeweils mit dem wenigstens einen zweiten Kanal (CH2; CH(N-1); CHN) verbunden sind, und
(f) wenigstens eine Schaltungseinrichtung (C2; C(N-1); CN), die jeweils mit wenigstens einem zweiten Kanal (CH2; CH(N-1); CHN) verbunden ist, zum jeweiligen Ausgleichen von Verzögerungen der Taktsignale, die jeweils durch den ersten Kanal (CH1) und den wenigstens einen zweiten Kanal (CH2; CH(N-1); CHN) laufen;
wobei
(g) der erste Puffer (11-1) und der wenigstens eine zweite Puffer (11-2; 11-(N-1); 11-N) die gleiche Ansteuerfähigkeit aufweisen;
(h) eine Gesamtlast des ersten Kanals (CH1) größer als eine Gesamtlast des wenigstens einen zweiten Kanals (CH2; CH-(N-1), CH-N) ist, jeweils ausschließlich der wenigstens einen Schaltungseinrichtung (C2; (C(N-1); CN); und
(i) die wenigstens eine Schaltungseinrichtung (C2; C(N-1); CN) eine Kapazität ist.

2. Taktversorgungsschaltung nach Anspruch 1,
dadurch **gekennzeichnet**, daß die wenigstens eine Schaltungseinrichtung (CH2; C(N-1); CN) mit dem wenigstens einen zweiten Kanal (CH2; CH(N-1); CHN) an einer jeweils zu dem wenistens einen zweiten Puffer (11-2; 11-(N-1); 11-N) gegenüberliegenden Seite verbunden ist.

3. Taktversorgungsschaltung, umfassend:
(a) einen Primärpuffer (10) zum Ansteuern eines Taktsignals;
(b) einen ersten Puffer (11-1), der mit dem Primärpuffer (10) durch eine erste Leitung zum Empfang des Taktsignals von dem Primärpuffer (10) verbunden ist;
(c) wenigstens einen zweiten Puffer (11-2; 11-(N-1); 11-N), der mit dem Primärpuffer (10) durch wenigstens eine zweite Leitung zum Empfang des Taktsignals von dem Primärpuffer (10) verbunden ist;
**gekennzeichnet** durch
(d) einen ersten Kanal (CH1), der mit dem ersten Puffer (11-1) verbunden ist, zum Liefern des Taktsignals von dem ersten Puffer (11-1) an mehr als ein erstes Flip-Flop (F/F11 bis F/F1p), die mit dem ersten Kanal (CH1) verbunden sind;
(e) wenigstens einen zweiten Kanal (CH2; CHh-(N-1); CH-N), der jeweils mit wenigstens einem zweiten Puffer (11-2; 11-(N-1); 11-N) verbunden ist, zum Liefern des Taktsignals von dem wenigstens einen zweiten Puffer (11-2; 11-(N-1); 11-N) an mehr als ein zweites Flip-Flop (F/F21 bis F/F2k; F/F(N-1)1 bis F/F/N-1)n; F/FN1 bis F/FNm), die jeweils mit dem wenigstenseinen zweiten Kanal (CH2; CH(N-1); CHN) verbunden sind;
(f) wenigstens eine Schaltungseinrichtung (C2; C(N-1); CN), die jeweils mit wenigstens einem zweiten Kanal (CH2; CH(N-1); CHN) verbunden ist, zum jeweiligen Ausgleichen von Verzögerungen der Taktsignale, die jeweils durch den ersten Kanal (CH1) und den wenigstens einen zweiten Kanal (CH2; CH(N-1); CHN) laufen;
wobei
(g) der erste Puffer (11-1) und der wenigstens eine zweite Puffer (11-2; 11-(N-1); 11-N) die gleiche Ansteuerfähigkeit aufweisen;
(h) eine Gesamtlast des ersten Kanals (CH1) größer als eine Gesamtlast des wenigstens einen zweiten Kanals (CH2; CH-(N-1), CH-N) ist, jeweils ausschließlich der wenigstens einen Schaltungseinrichtung (C2; (C(N-1); CN); und
(i) die wenigstens eine Schaltungseinrichtung (C2; C(N-1); CN) eine Kapazität ist;
(j) wenigstens eine zweite Schaltungseinrichtung (C12; C1(N-1); C1N), die jeweils mit wenigstens einer zweiten Leitung verbunden ist, zum im wesentlichen Ausgleichen von Verzögerungen der Taktsignale, die jeweils durch die erste Leitung und die wenigstens eine zweite Leitung laufen;
wobei
(k) eine Gesamtlast der ersten Leitung größer ist als eine Gesamtlast der wenigstens einen zweiten Leitung ist, ausschließlich jeweils der wenigstens einen zweiten Schaltungseinrichtung (C12; C1(N-1); C1N); und
(l) die wenigstens eine zweite Schaltungseinrichtung (C12; C1(N-1); C1N) eine Kapazität ist.

4. Taktversorgungsschaltung nach einem der vorangehenden Ansprüche,
dadurch **gekennzeichnet**, daß die Gesamtlast des ersten Kanals (CH1) durch seine Länge und die ersten Flip-Flops (F/F11 bis F/1p) bestimmt ist und die Gesamtlast des wenigstens einen zweiten Kanals (CH2; CH(N-1); CHN) jeweils durch seine Länge und die wenigstens einen zweiten Flip-Flop (F/F21 bis F/F2k; F/F(N-1)1 bis F/F(N-1)n; F/FN1 bis F/FNm) bestimmt ist.

5. Taktversorgungsschaltung nach einem der Ansprüche 1 bis 4,
dadurch **gekennzeichnet**, daß der erste Kanal (CH1) und der wenigstens eine zweite Kanal (CH2; CH(N-1); CHN) die gleiche Anzahl von jeweils damit verbundenen Flip-Flops aufweisen und sich in der Länge unterscheiden.

6. Taktversorgungsschaltung nach einem der Ansprüche 1 bis 4,
dadurch **gekennzeichnet**, daß der erste Kanal (CH1) und der wenigstens eine zweite Kanal (CH2; CH(N-1); CHN) gleiche Länge aufweisen und sich in der Anzahl von jeweils damit verbunden Flip-Flops unterscheiden.

## Revendications

1. Circuit fournissant un signal d'horloge, comprenant
(a) un circuit tampon primaire (10) destiné à attaquer avec un signal d'horloge,
(b) un premier circuit tampon (11-1) relié audit circuit tampon primaire (10) par l'intermédiaire d'une première ligne afin de recevoir le signal d'horloge provenant dudit circuit tampon primaire (10),
(c) au moins un second circuit tampon (11-2, 11-(N-1), 11-N) relié audit circuit tampon primaire (10) par l'intermédiaire d'au moins une seconde ligne destinée à recevoir le signal d'horloge provenant dudit circuit tampon primaire (10), lesdites première et seconde lignes étant égales en longueur,
caractérisé par
(d) un premier canal (CH1) relié audit premier circuit tampon (11-1) destiné à appliquer le signal d'horloge provenant dudit premier circuit tampon 11-1 à plus d'une bascule parmi des premières bascules (F/F11 à F/F1p) reliées audit premier canal (CH1),
(e) au moins un second canal (CH2, CH-(N-1), CH-N) relié respectivement audit au moins un second circuit tampon (11-2, 11-(N-1), 11-N) destiné à appliquer le signal d'horloge provenant dudit au moins un second circuit tampon (11-2, 11-(N-1), 11-N) à plus d'une bascule parmi des secondes bascules (F/F21 à F/F2k, F/F(N-1)1 à F/F(N-1)n, F/FN1 à F/FNm) respectivement reliées audit au moins un second canal (CH2, CH(N-1), CHN), et
(f) au moins un moyen de circuit (C2, C(N-1), CN) respectivement relié à au moins un second canal (CH2, CH(N-1), CHN) de façon à égaliser pratiquement les retards des signaux d'horloge passant respectivement par ledit premier canal (CH1) et ledit au moins un second canal (CH2, CH(N-1), CHN),
dans lequel
(g) ledit premier circuit tampon (11-1) et ledit au moins un second circuit tampon (11-2, 11-(N-1), 11-N) présentent la même capacité d'attaque,
(h) une charge totale dudit premier canal (CH1) est supérieure à une charge totale dudit au moins un second canal (CH2, CH-(N-1), CH-N), respectivement, à l'exception dudit au moins un moyen de circuit (C2, C(N-1), CN), et
(i) ledit au moins un moyen de circuit (C2, C(N-1), CN) est une capacité.

2. Circuit fournissant un signal d'horloge selon la revendication 1, dans lequel ledit au moins un moyen de circuit (C2, C(N-1), CN) est relié audit au moins un second canal (CH2, CH(N-1), CHN) à un côté opposé audit au moins un second circuit tampon ( 11-2, 11-(N-1), 11-N), respectivement.

3. Circuit fournissant un signal d'horloge, comprenant
(a) un circuit tampon primaire (10) destiné à attaquer avec un signal d'horloge,
(b) un premier circuit tampon (11-1) relié audit circuit tampon primaire (10) par l'intermédiaire d'une première ligne afin de recevoir le signal d'horloge provenant dudit circuit tampon primaire (10),
(c) au moins un second circuit tampon (11-2, 11-(N-1), 11-N) relié audit circuit tampon primaire (10) par l'intermédiaire d'au moins une seconde ligne destinée à recevoir le signal d'horloge provenant dudit circuit tampon primaire (10),
caractérisé par
(d) un premier canal (CH1) relié audit premier circuit tampon (11-1) destiné à appliquer le signal d'horloge provenant dudit premier circuit tampon (11-1) à plus d'une bascule parmi des premières bascules (F/F11 à F/F1p) reliées audit premier canal (CH1),
(e) au moins un second canal (CH2, CH-(N-1), CH-N) relié respectivement audit au moins un second circuit tampon (11-2, 11-(N-1), 11-N) destiné à appliquer le signal d'horloge provenant dudit au moins un second circuit tampon (11-2, 11-(N-1), 11-N) à plus d'une bascule parmi des secondes bascules (F/F21 à F/F2k, F/F(N-1)1 à F/F(N-1)n, F/FN1 à F/FNm) respectivement reliées audit au moins un second canal (CH2, CH(N-1), CHN), et
(f) au moins un moyen de circuit (C2, C(N-1), CN) respectivement relié à au moins un second canal (CH2, CH(N-1), CHN) destiné à pratiquement égaliser les retards des signaux d'horloge passant respectivement dans ledit premier canal (CH1) et ledit au moins un second canal (CH2, CH(N-1), CHN),
dans lequel
(g) ledit premier circuit tampon (11-1) et ledit au moins un second circuit tampon (11-2, 11-(N-i), 11-N) présentent la même capacité d'attaque,
(h) une charge totale dudit premier canal (CH1) est supérieure à une charge totale dudit au moins un second canal (CH2, CH-(N-1), CH-N), respectivement, à l'exception dudit au moins un moyen de circuit (C2, C(N-1), CN),
(i) ledit au moins un moyen de circuit (C2, C(N-1), CN) est une capacité.
(j) au moins un second moyen de circuit (C12, C1(N-1), C1N) respectivement relié à au moins une seconde ligne afin de pratiquement égaliser les retards des signaux d'horloge passant respectivement par ladite première ligne et ladite au moins une seconde ligne,
dans lesquels
(k) une charge totale de ladite première ligne est supérieure à une charge totale de ladite au moins une seconde ligne à l'exception dudit au moins un second moyen de circuit (C12, C1(N-1), C1N), respectivement, et
(l) ledit au moins un second moyen de circuit (C12, C1(N-1), C1N) est une capacité.

4. Circuit fournissant un signal d'horloge selon l'une quelconque des revendications précédentes, dans lequel la charge totale dudit premier canal (CH1) est déterminée par sa longueur et lesdites premières bascules (F/F11 à F/F1p) et la charge totale dudit au moins un second canal (CH2, CH(N-1), CHN) respectivement est déterminée par sa longueur et ladite au moins une seconde bascule (F/F21 à F/F2k, F/F(N-1)1 à F/F(N-1)n, F/FN1 à F/FNm).

5. Circuit fournissant un signal d'horloge selon l'une quelconque des revendications 1 à 4, dans lequel ledit premier canal (CH1) et ledit au moins un second canal (CH2, CH(N-1), CHN, sont égaux en nombre de bascules respectivement reliées à ceux-ci, et diffèrent au point de vue longueur.

6. Circuit fournissant un signal d'horloge selon l'une quelconque des revendications 1 à 4, dans lequel ledit premier canal (CH1) et ledit au moins un second canal (CH2, CH(N-1), CHN) sont égaux au point de vue longueur et diffèrent en nombre des bascules respectivement reliées à ceux-ci.
